(19) Europäisches Patentamt / European Patent Office / Office européen des brevets

(11) **EP 1 348 968 B1**

(12) **FASCICULE DE BREVET EUROPEEN**

(45) Date de publication et mention
de la délivrance du brevet:
**16.04.2008 Bulletin 2008/16**

(51) Int Cl.:
*G01R 19/02* (2006.01)     *G01R 21/133* (2006.01)

(21) Numéro de dépôt: **03290648.9**

(22) Date de dépôt: **14.03.2003**

(54) **Circuit numérique de mesure de la puissance d'un signal**

Digitale Schaltung zur Signalleistungsmessung

Digital circuit for measuring signal power

(84) Etats contractants désignés:
**DE ES GB IT**

(30) Priorité: **28.03.2002 FR 0203889**

(43) Date de publication de la demande:
**01.10.2003 Bulletin 2003/40**

(73) Titulaire: **AGENCE SPATIALE EUROPEENNE**
**F-75738 Paris Cedex 15 (FR)**

(72) Inventeurs:
• **Martin Neira, Manuel**
  **2343 HS Oegstgeest (NL)**
• **Piironen, Petri Viljo Emil**
  **2202 JN Noordwijk (NL)**
• **Camps Carmona, Adriano José**
  **08017 Barcelona (ES)**
• **Sempere Payà, Luis**
  **46022 Valencia (ES)**

(74) Mandataire: **Jacquard, Philippe Jean-Luc et al**
**Cabinet ORES**
**36, rue de St Pétersbourg**
**75008 Paris (FR)**

(56) Documents cités:
• **PATENT ABSTRACTS OF JAPAN vol. 012, no. 350 (P-760), 20 septembre 1988 (1988-09-20) & JP 63 103976 A (FUJI ELECTRIC CO LTD), 9 mai 1988 (1988-05-09)**
• **TIURI M.E. ET AL: 'Digital measurement of narrowband noise power' PROCEEDINGS OF THE IEEE vol. 55, no. 9, Septembre 1967, pages 1577 - 1582**

## Description

La présente invention a pour objet un circuit numérique permettant de mesurer la tension effective et/ou la puissance d'un signal, destiné notamment à mesurer la puissance d'un bruit thermique.

On connaît déjà de l'article de MARTTI E. TIURI intitulé « Digital Measurement of Narrowband Noise Power » publié dans « Proceedings of the IEEE, vol. 55 n° 9 - Septembre 1967 », un circuit numérique qui génère une impulsion de sortie chaque fois que l'amplitude de la tension de bruit dépasse un niveau de seuil Vo.

A partir du nombre d'impulsions recueillies, il est possible de calculer la puissance du signal à l'aide d'une formule qui n'est pas linéaire.

De plus, le procédé décrit n'est applicable qu'au cas de bruit ayant une faible bande passante.

Au moins un inconvénient précité est évité grâce à un circuit selon la présente invention.

L'invention concerne ainsi un circuit numérique permettant de mesurer la tension effective d'un signal, comportant au moins un module présentant un étage échantillonneur présentant une sortie générant un signal logique de sortie, présentant pour chaque période donnée d'échantillonnage, un niveau représentant la valeur de la tension du signal par rapport à au moins un seuil donné $\underline{A}$, caractérisé en ce qu'il comporte un circuit de calcul d'une valeur représentative de ladite tension effective en fonction de la différence entre le nombre de fois où le signal logique de sortie indique que ladite tension du signal est supérieure au seuil donné A et le nombre de fois où le signal logique de sortie indique que ladite tension du signal est inférieure ou égale audit seuil donné $\underline{A}$ sur une durée d'intégration correspondant à N périodes données d'échantillonnage.

Le circuit de calcul peut être caractérisé en ce qu'il présente :

- un corrélateur cadencé par une horloge à ladite période d'échantillonnage, et présentant un circuit logique de comparaison ayant une première entrée recevant ledit signal logique de sortie et une deuxième entrée dite de comparaison à laquelle est appliqué un signal logique d'entrée (0 ou 1), et une sortie délivrant à chaque période du signal d'horloge un signal logique de comparaison entre les signaux logiques présents aux première et deuxième entrées du circuit logique de comparaison, et un circuit d'accumulation pour accumuler le signal logique de comparaison pendant lesdites N périodes d'échantillonnage et produire un signal logique de corrélation.
- et un circuit de détermination d'une valeur représentative de ladite tension effective en fonction de la différence entre le nombre de fois où le signal logique de comparaison est au niveau logique 0 et le nombre de fois où il est au niveau logique 1 sur N périodes du signal d'horloge, cette détermination s'effectuant à partir du signal logique de corrélation.
  La période donnée est avantageusement celle d'une horloge qui cadence l'étage échantillonneur.
  Selon un mode de réalisation particulier, le circuit est caractérisé en ce que l'étage échantillonneur comporte
- un comparateur ayant une entrée de signal et une entrée d'un niveau de seuil recevant un signal représentant le seuil donné et une sortie générant un signal de comparaison représentant le fait que la valeur de la tension du signal est ou non supérieure audit seuil.
- une bascule ayant une entrée connectée à la sortie du comparateur et une entrée d'un signal d'horloge ayant ladite période donnée et une sortie générant ledit signal logique de sortie qui représente pour chaque période dudit signal d'horloge une valeur du signal logique en sortie du comparateur.

Ladite valeur représentative est avantageusement proportionnelle à :

$$X' = 2\,|\,X - N/2\,|\,/N :$$

X est le nombre d'échantillons en sortie du corrélateur qui ont la valeur $\varnothing$, et N désigne le nombre total d'échantillons.

Ledit circuit logique de corrélation est, par exemple une porte du type OU exclusif $XOR$ ou $\overline{XOR}$, délivrant à sa sortie le signal logique de comparaison.

Le circuit peut être caractérisé en ce que le circuit d'accumulation est un circuit de comptage accumulant pendant N périodes d'échantillonnage la valeur du signal logique de comparaison et délivrant en sortie le signal numérique de corrélation représentant le nombre de fois où le signal logique de comparaison est à un niveau donné (0 ou 1), ledit signal numérique qui constitue le signal de sortie du module étant introduit à une entrée du circuit (CIRC) de détermination d'une valeur représentative.

Le circuit peut présenter n modules tels que définis ci-dessus, ces n modules présentant des seuils différents $a_1$, $a_2$, ....$a_n$ et étant montés en parallèle.

Le circuit peut être associé à un circuit de traitement qui, à partir des n signaux de sortie par exemple X1, X2 ...

$X_n$ disponibles en sortie des n modules, détermine une distribution fréquentielle estimée fe, et éventuellement l'écart entre cette distribution fe et la distribution gaussienne fo la plus proche.

D'autres caractéristiques et avantages de l'invention apparaîtront mieux à la lecture de la description qui va suivre, donnée à titre d'exemple non limitatif, en liaison avec les dessins annexés dans lesquels :

- la figure 1 illustre un mode de réalisation d'un détecteur selon l'invention mettant en oeuvre un circuit d'échantillonnage sur un bit,
- la figure 2 illustre un mode de réalisation d'un détecteur selon l'invention mettant en oeuvre n circuits d'échantillonnage sur un bit,
- les figures 3a à 3d illustrent une évaluation du niveau d'un bruit non gaussien à l'aide d'un circuit à n modules selon la figure 2,
- et les figures 4 et 5 illustrent une mise en oeuvre préférée de l'invention.

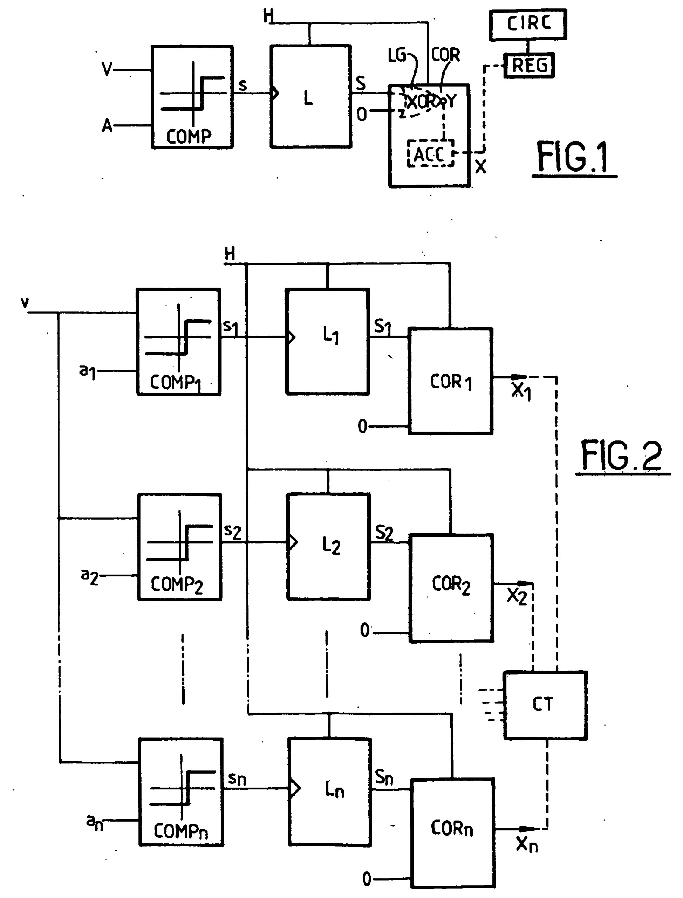

La figure 1 montre un module permettant la mesure de puissance.

Il comporte en cascade un comparateur COMP qui fait fonction de quantificateur 1 bit, une bascule L et un corrélateur COR.

Le comparateur COMP présente une entrée de signal qui reçoit le signal de tension V et une entrée de référence qui reçoit un signal A représentant le seuil de comparaison.

Si la tension V est supérieure à A , alors le signal de sortie s du comparateur COMP est un 1 logique.

Si la tension V est inférieure ou égale à A, alors le signal de sortie s du comparateur COMP est un $\varnothing$ logique.

La bascule L («flip-flop ») est un bistable qui permet de mémoriser la valeur binaire de son entrée (le signal s généré par le comparateur COMP) à chaque front descendant d'un signal d'horloge H. De ce fait, les variations du signal s entre deux fronts descendants de l'horloge H n'ont pas d'effet sur la sortie S de la bascule L.

Le corrélateur COR est un circuit logique à deux entrées et une sortie. Il comporte un accumulateur ACC et éventuellement une porte logique LG en cascade avec l'accumulateur ACC. La porte logique LG est en particulier une porte OU exclusif ($XOR$) ou une porte OU exclusif inversée ($\overline{XOR}$).

La porte logique LG cadencée par l'horloge H reçoit à une entrée $E_1$ le signal S et à son autre entrée $E_2$ un signal logique qui est constant dans le temps, et qui peut être un 0 ou bien un 1. La porte LG délivre à sa sortie un signal logique Y.

Dans le cas d'une porte $\overline{XOR}$, la table de vérité est la suivante :

Cas 1 : $E_2 = 0$

| $E_1$ | $E_2$ | Y |
|---|---|---|
| 0 | 0 | 1 |
| 1 | 0 | 0 |

Cas 2 : $E_2 = 1$

| $E_1$ | $E_2$ | Y |
|---|---|---|
| 0 | 1 | 0 |
| 1 | 1 | 1 |

L'accumulateur ACC est un compteur cadencé par l'horloge H qui sert à compter le nombre de fois où le signal S est à un niveau donné. Par exemple, à chaque période de l'horloge H, le compte de l'accumulateur ACC est incrémenté de 1 si la sortie S de la bascule L est au niveau 1, et reste au même niveau si la sortie S est au niveau 0. Au bout d'un certain temps d'intégration (correspondant à N périodes de l'horloge H), le contenu X de l'accumulateur ACC (dit signal de corrélation) est transféré à un registre REG et l'accumulateur ACC est remis à zéro, pour effectuer un autre cycle d'intégration de même durée ou de durée différente. Alternativement, l'accumulateur ACC est situé hors du module et fait par exemple partie du circuit de calcul CIRC. Dans ce cas le corrélateur est en deux parties, une dans le module d'entrée qui, à partir du signal V, génère le signal S ou Y, et une dans le module de calcul incluant le circuit CIRC. Le signal Y (ou le signal S) constitue alors la sortie du module, et l'accumulation des résultats est réalisée à l'extérieur du ou des modules, par exemple dans le circuit CIRC.

Dans ce mode de réalisation, le résultat de la corrélation (sortie X) représente le nombre X de 0 ou de 1 présents en sortie de la bascule L pendant la durée d'intégration (N périodes de l'horloge H).

Soit X le nombre de 0 et N le nombre d'échantillons pendant le temps d'intégration.

On calcule un nombre X' :

$$X' = 2(X - N/2)/N$$

X' est inversement proportionnel à la valeur effective $\sigma_v$ (« rms ») de la tension v :

$$X' = \sqrt{2/\Pi} \; A/\sigma_v$$

La puissance moyenne peut être obtenue en élevant au carré la tension effective $\sigma_v$.

Un module unique tel que décrit ci-dessus peut être utilisé dans des applications telles que la détermination de la puissance d'un signal, ou bien pour la détection d'interférence dans un système de radiométrie notamment interférentiel, ou pour permettre une correction des interférences.

Bien entendu, le résultat ci-dessus peut être obtenu par d'autres procédés de comptage, le procédé ci-dessus illustrant un mode de réalisation préféré.

La détection d'une tension effective (« rms ») peut être réalisée (voir figure 2) en utilisant en parallèle n modules selon la figure 1, cadencés par la même horloge avec n seuils de comparaison $a_1$, $a_2$, .....$a_n$ pour les comparateurs $COMP_1$, $COMP_2$, ....$COMP_n$ en cascade avec les bascules $L_1$, $L_2$, ..$L_n$ qui délivrent des signaux $S_1$, $S_2$, .... $S_n$. On obtient à partir des signaux $S_1$, $S_2$, ... $S_n$, n signaux $X_1$, $X_2$, .... $X_n$ en sortie des corrélateurs $COR_1$, $COR_2$, ... $COR_n$.

Pour la détection des interférences dans un système radiométrique, il est préférable d'utiliser n modules en parallèle selon la figure 2.

Les systèmes radiométriques reçoivent des radiations émises par des sources thermiques pour lesquelles la distribution en amplitude est gaussienne. Si le signal de bruit reçu est contaminé par une interférence indésirable, la distribution du signal n'est plus gaussienne. Dans les conditions habituelles, la contamination du signal peut être déterminée seulement après un post-traitement du signal.

La mise en oeuvre de plusieurs modules en parallèle avec des seuils différents qui correspondent à la distribution sans contamination, permet de mesurer en temps réel la forme de la distribution et donc de détecter la contamination interférentielle tout en évitant un post-traitement des données contaminées.

L'estimation de la distribution du signal est obtenue à l'aide d'un circuit de traitement CT à partir des nombres $X_1$, $X_2$, ... $X_n$ obtenus à la sortie de chacun des modules, dont chacun a un niveau de référence $a_1$, $a_2$, ... $a_n$ différent.

Il est bien entendu possible de réaliser l'accumulation des résultats (signaux $X_1$, $X_2$, ... $X_n$) dans le circuit CT.

A partir de chacun des nombres $X_1$, $X_2$, ...$X_i$...$X_n$ on calcule les nombres $X'_1$, $X'_2$, ... $X'_i$ ...$X'_n$ avec :

$$X'_i = 2(X_i - N/2)/N$$

Lorsque $a_{i+1} > a_i$ pour i = 1, 2 - n, alors on a $X'_{i+1} < X'_i$, $X'_i$ désignant le nombre de corrélations obtenues pendant une durée d'intégration couvrant N périodes de l'horloge H.

A partir des différences $X'_i - X'_{i+1}$, on obtient le nombre d'échantillons de tension d'entrée V qui sont compris entre les seuils $a_i$ et $a_{i+1}$.

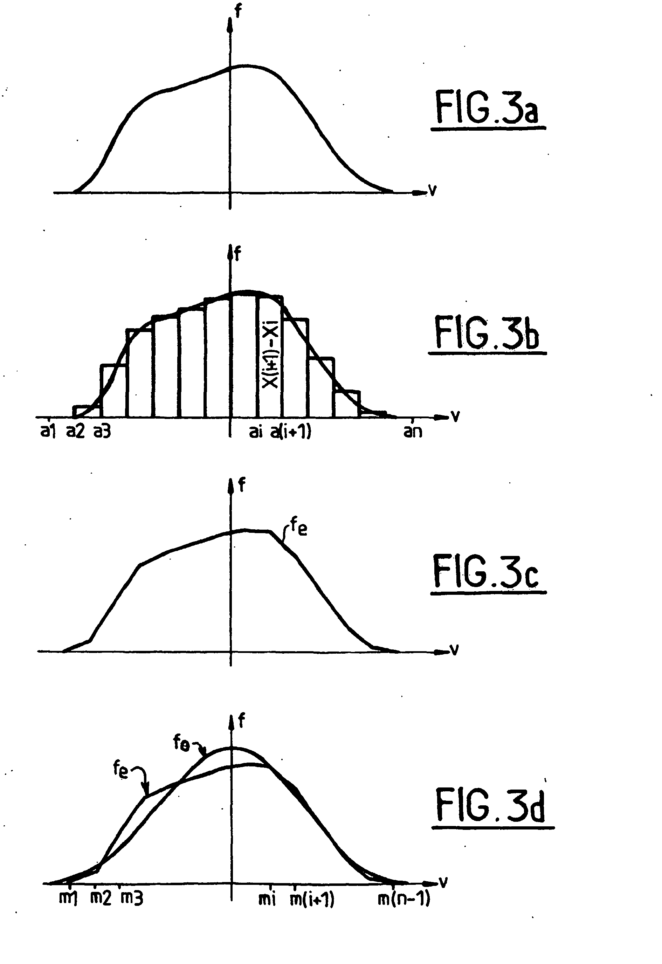

La valeur estimée $f_e$ de la densité de distribution de la tension v est obtenue par exemple en calculant les différences en fonction du point milieu $m_i = (a_i + a_{i+i})/2$. La figure 3a montre la densité de distribution du signal v, la figure 3b montre l'échelonnement des seuils, et la figure 3c montre l'estimation $f_e$ de la densité de distribution du signal V.

Le degré de contamination du bruit gaussien par des interférences peut être déterminé en calculant l'erreur entre la distribution estimée $f_e$ et la distribution gaussienne la plus proche fo déterminée par la méthode des moindres carrés (voir figure 3d).

L'erreur E est alors calculée de la manière suivante :

$$E = \sqrt{\sum_{i=1}^{n-1} \left[ f_e(m_i) - f_0(m_i) \right]^2}$$

ce qui correspond à la racine carrée de la surface comprise entre les deux courbes de la figure 3d.

Pour un signal E purement gaussien, E est égal à zéro, ou très voisin de zéro. E croît avec le degré de contamination. On peut alors décider de rejeter un signal si E dépasse un seuil donné.

La puissance du signal est donnée par la formule suivante :

$$P = V^2_{rms} = \sum_{i=1}^{n-1} (X'_i - X'_{i+1})m^2_i$$

Il existe des conditions sur les valeurs des seuils qui doivent être satisfaites si on souhaite obtenir une précision élevée.

Pour un détecteur de valeur effective $\sigma_v$ (« rms ») d'une tension, opérant avec une quantification sur un bit, il faut que le seuil A soit très inférieur à la tension effective $\sigma$, et en pratique :

$$A \le \frac{\sigma_v}{10}$$

L'erreur relative $\Delta X'/X'$ peut être déterminée à l'aide de la formule :

$$\frac{\Delta X'}{X'} = -\frac{1}{6}\left(\frac{A}{\sigma_v}\right)^2$$

Pour $A/\sigma_v = 10$ on a $\Delta X'/X' = -1,7 \cdot 10^{-3}$.

En outre, plus le nombre d'échantillons N est élevé, plus faible est l'erreur sur la puissance relative. Les meilleures applications du dispositif selon l'invention sont celles où le temps d'intégration n'est pas critique, c'est-à-dire, en particulier celles où les dérives telles que les dérives thermiques de la ou des tensions de seuil $a_i$ ne sont pas significatives.

Par rapport à un détecteur quadratique connu, ayant un temps d'intégration T, il faut en effet, avec un dispositif selon l'invention, un temps d'intégration $T_D$ pour obtenir la même précision. On a :

$$T_D = \pi T \, (\sigma_v \, /A)^2.$$

Un dispositif selon l'invention présente une faible sensibilité à la température, une grande linéarité sur une large gamme dynamique.

Il est pratiquement dépourvu de dérive (« offset »).

En général, il présente une sensibilité plus faible qu'un détecteur quadratique, mais cet inconvénient est compensé si on augmente la durée d'intégration.

L'invention nécessite des circuits rapides qui peuvent fonctionner à une fréquence égale à au moins 2,2 B, pour un signal V de bande passante B (pour respecter le théorème de l'échantillonnage).

Le corrélateur doit être capable de traiter un nombre d'échantillons de l'ordre de $10^8$, ce qui ne pose pas de problème avec un compteur à 4 octets (32 bits).

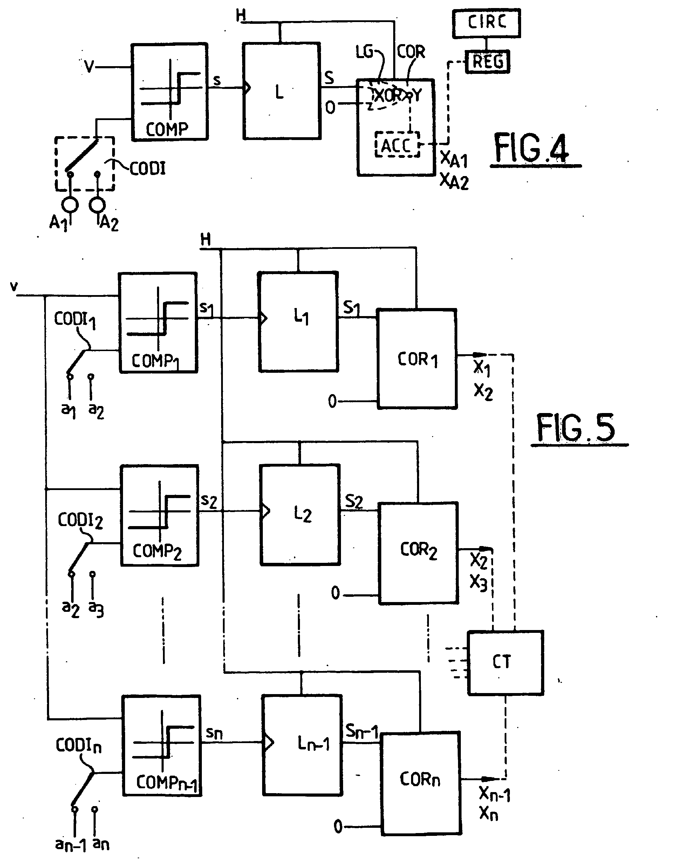

La figure 4 illustre un mode de réalisation préféré de l'invention selon lequel il est possible de compenser la dérive à l'entrée du comparateur, en pratique un circuit intégré du commerce (amplificateur différentiel, également dénommé amplificateur opérationnel). Dans de tels circuits, même thermostatés ou compensés en température, il apparaît à l'entrée une tension de dérive td qui tend à augmenter lentement avec le temps. Du fait qu'il s'agit d'un phénomène lent, il est possible de l'éliminer dans une large mesure en effectuant la comparaison, non pas par référence à un seuil unique A comme dans les modes de réalisation précédents, mais en utilisant deux tensions de seuil, A1 et A2, comme indiqué à la figure 4 avec un commutateur CODI permettant d'appliquer au comparateur COMP le seuil A1 ou le seuil A2. Ces tensions de seuil A1 et A2 peuvent être générées à partir de générateurs thermostatés et/ou compensés en température, qui sont eux stables dans le temps.

Au cours d'une période d'intégration, on obtient $X_{A1}$ zéros par rapport au seuil A1, et $X_{A2}$ zéros par rapport au seuil A2.

On peut réaliser cette intégration pour le seuil A1, puis pour le seuil A2, mais cette intégration est préférentiellement réalisée en alternance (un échantillon pour le seuil A1, un échantillon pour le seuil A2, puis de nouveau un échantillon pour le seuil A1 et ainsi de suite).

En raison de la tension de dérive td à l'entrée du comparateur COMP, la comparaison ne s'effectue pas par rapport au seuil A1 et au seuil A2, mais au seuil A1 + td et au seuil A2+ td.

On a :

$$X'_{A1} = 2(X_{A1} - N1/2)/ N1$$

$$X'_{A2} = 2(X_{A2} - N2/2)/ N2.$$

N.B. : En pratique, on choisit : N1 = N2 = N

On a :

$$X'_{A1} = \sqrt{2/\Pi}\ \frac{A_1 + t_d}{\sigma_v}$$

$$X'_{A2} = \sqrt{2/\Pi}\ \frac{A_2 + t_d}{\sigma_v}$$

et il en résulte :

$$X'_{A1} - X'_{A2} = \sqrt{2/\Pi}\ \frac{A_1 - A_2}{\sigma_v} = 2(X_{A1} - X_{A2})/N$$

ce qui permet de déterminer $\sigma_v$ en éliminant la dérive td.

Une élimination optimale de la dérive td est obtenue en utilisant, en tant que commutateur CODI, un commutateur de Dicke.

Un tel commutateur est par exemple décrit dans l'ouvrage de Fawwaz T. ULABY et Collaborateurs intitulé "Microwave Remote Sensing" vol. 1 "Microwave Remote Sensing - Fundamentals and Radiometry" pages 369 à 374 ("6-9 Dicke Radiometer").

Le commutateur de Dicke CODI commute périodiquement l'entrée de seuil entre les valeurs $A_1$ et $A_2$. La sortie S de la bascule L est comptée de manière synchrone avec la commutation du communateur de Dicke, pour chacun des seuils $A_1$ et $A_2$, de manière à mémoriser dans l'accumulateur ACC, d'une part le compte $X_{A1}$ et d'autre part le compte $X_{A2}$.

On peut ensuite calculer la différence $X_{A1} - X_{A2}$ et donc $\sigma_v$.

Le même principe peut être appliqué au mode de réalisation de la figure 2, en associant à chaque comparateur $COMP_1$, $COMP_2$ ... $COMP_n$, non pas un, mais deux seuils, à savoir les seuils $a_1$ et a2 pour le comparateur $COMP_1$, $a_2$ et $a_3$ pour le comparateur $COMP_2$ et ainsi de suite, avec les seuils $a_{n-1}$ et $a_n$ pour le comparateur $COMP_{n-1}$.

La commutation entre les seuils est assurée par des commutateurs $CODI_1$, $CODI_2$ ... $CODI_{n-1}$, par exemple des commutateurs de Dicke.

Le corrélateur $COR_1$ délivre ainsi des signaux $X_1$ et $X_2$ associés respectivement aux seuils $a_1$ et $a_2$ appliqués au comparateur $COMP_1$ pour calculer X'1 - X'2, avec compensation de la dérive à l'entrée de $COMP_1$.

La corrélation $COR_2$ délivre les signaux $X_2$ et $X_3$ associés respectivement aux seuils $a_2$ et $a_3$ appliqués au comparateur $COMP_2$ pour calculer $X'_2 - X'_3$, avec compensation de la dérive à l'entrée de $COMP_2$, et ainsi de suite jusqu'au corrélateur $COR_{n-1}$ en passant par le corrélateur $COR_i$ qui délivre les signaux $X_i$ et $X_{i+1}$ associés respectivement aux seuils $a_i$ et $a_{i+1}$ appliqués au comparateur $COMP_i$ pour calculer $X'_i - X'_{i+1}$ avec compensation de la dérive à l'entrée de $COMP_i$.

Ainsi, chacune des différences obtenues est compensée de la dérive d'entrée du comparateur associé. La puissance P est calculée à partir de différences dont chacune est compensée de la dérive.

Comme dans le cas des figures 1 et 2, il existe une condition pour que les résultats obtenus aient une bonne précision.

On choisira :

$$A_1 - A_2 \approx \frac{\sigma \min}{10}$$

$\sigma\min$ désignant la valeur minimale de $\sigma_v$.

## Revendications

1. Circuit numérique permettant de mesurer la tension effective d'un signal d'entrée, comportant au moins un module présentant un étage échantillonneur présentant une sortie générant un signal logique de sortie qui présente pour chaque période donnée d'échantillonnage, un niveau représentant la valeur de la tension du signal par rapport à au moins un seuil donné (A), **caractérisé en ce qu'**il comporte un circuit (CIRC) de calcul d'une valeur représentative de ladite tension effective en fonction de la différence entre le nombre de fois où le signal logique de sortie (S) indique que la tension du signal d'entrée est supérieure au seuil donné (A) et le nombre de fois où le signal logique de sortie (S) indique que cette tension est inférieure audit seuil donné (A) sur une durée correspondant à N périodes données d'échantillonnage.

2. Circuit selon la revendication 1, **caractérisé en ce qu'**il présente un circuit de commutation (COD$_l$) permettant d'appliquer au circuit numérique un premier (A$_1$) et un deuxième (A$_2$) seuils donnés différents et en ce qu'il comporte un dit circuit (CIRC) de calcul de ladite tension effective en fonction d'une part de la différence entre le nombre de fois où le signal logique de sortie (S) indique que la tension du signal d'entrée est supérieure au premier seuil donné (A$_1$) et le nombre de fois où le signal logique de sortie (S) indique que cette tension est inférieure audit premier seuil donné (A$_1$) et d'autre part en fonction de la différence entre le nombre de fois où le signal logique de sortie (S) indique que la tension du signal d'entrée est supérieure au deuxième seuil donné (A$_2$) et le nombre de fois où le signal logique de sortie (S) indique que cette tension est inférieure audit deuxième seuil donné (A$_2$).

3. Circuit selon une des revendications 1 ou 2, **caractérisé en ce que** le circuit de calcul présente :

   - un corrélateur (COR) cadencé par une horloge (H) à ladite période d'échantillonnage, et présentant un circuit logique de comparaison ayant une première entrée recevant ledit signal logique de sortie (S) et une deuxième entrée dite de comparaison à laquelle est appliqué un signal logique d'entrée (0 ou 1), et une sortie délivrant à chaque période du signal d'horloge un signal logique de comparaison (Y) entre les signaux logiques présents aux première et deuxième entrées du circuit logique de comparaison, et un circuit (ACC) d'accumulation pour accumuler le signal logique de comparaison (Y) pendant les N périodes d'échantillonnage et produire un signal logique de corrélation (X),
   - et un circuit (CIRC) de détermination d'une valeur représentative de ladite tension effective en fonction de la différence (X') entre le nombre de fois où pour chaque dit seuil donné le signal logique de comparaison (Y) est au niveau logique 0 et le nombre de fois où cette sortie est au niveau logique 1 sur N périodes du signal d'horloge (H), cette détermination s'effectuant à partir du signal logique de corrélation (X).

4. Circuit selon une des revendications 1 à 3, **caractérisé en ce que** ladite période donnée est la période d'une horloge (H) qui cadence l'étage échantillonneur.

5. Circuit selon la revendication 4, **caractérisé en ce que** l'étage échantillonneur comporte:

   - un comparateur (COMP) ayant une entrée de signal pour recevoir le signal d'entrée et une entrée d'un niveau de seuil recevant un signal (A) représentant le seuil donné et une sortie générant un signal de comparaison (s) représentant le fait que la valeur de la tension du signal d'entrée est ou non supérieure audit seuil (A).
   - une bascule (L) ayant une entrée connectée à la sortie du comparateur (COMP) et une entrée d'un signal d'horloge (H) ayant ladite période donnée et une sortie générant ledit signal logique de sortie (S) qui représente pour chaque période dudit signal d'horloge une valeur du signal logique (s) en sortie du comparateur (COMP).

6. Circuit selon une des revendications 3 à 6, **caractérisé en ce que** le corrélateur (COR) comporte une porte OU exclusive (XOR) délivrant à sa sortie ledit signal logique de corrélation (Y).

**7.** Circuit selon la revendication 6, **caractérisé en ce que** ladite porte est une porte OU exclusive inversée ($\overline{XOR}$).

**8.** Circuit selon une des revendications précédentes, **caractérisé en ce qu'**une dite valeur représentative est proportionnelle à :

$$X' = 2 \, |X - N/2| / N$$

X étant le nombre d'échantillons en sortie du corrélateur ayant pour un dit seuil donné la valeur 0, et N désignant le nombre total d'échantillons.

**9.** Circuit selon les revendications 2 à 8, **caractérisé en ce que** le circuit d'accumulation est un circuit de comptage (ACC) accumulant pendant N périodes d'échantillonnage la valeur du signal logique de comparaison (Y) et délivrant en sortie ledit signal numérique de corrélation (X) représentant le nombre de fois où le signal logique de comparaison est à un niveau donné (0 ou 1), ledit signal numérique (X) qui constitue le signal de sortie du corrélateur (COR) étant introduit à une entrée du circuit (CIRC) de détermination d'une valeur représentative.

**10.** Circuit numérique **caractérisé en ce qu'**il présente n modules selon une des revendications 1 et 3 à 9, chacun de ces n modules présentant l'un de n seuils différents ($a_1$, $a_2$, ... $a_n$) et étant montés en parallèle.

**11.** Circuit numérique **caractérisé en ce qu'**il présente n - 1 modules selon une des revendications précédentes, chacun de ces n modules présentant deux seuils différents, un premier module présentant un premier ($a_1$) et un deuxième ($a_2$) seuils, un deuxième module présentant le deuxième ($a_2$) et un troisième ($a_3$) seuils, et ainsi de suite jusqu'au (n - 1)$^{\text{ème}}$ module qui présente un (n-1)$^{\text{ème}}$ seuil ($a_{n-1}$) et un n $^{\text{ème}}$ seuil ($a_n$).

**12.** Circuit selon une des revendications 10 ou 11, **caractérisé en ce qu'**il est associé à un circuit de traitement qui, à partir des n signaux de sortie ($X_1$, $X_2$,.... $X_n$) des n modules, détermine une distribution fréquentielle estimée $f_e$ de la tension du signal V.

**13.** Circuit selon la revendication 12, **caractérisé en ce que** le circuit de traitement présente également un module de calcul pour calculer l'erreur entre ladite distribution estimée $f_e$ et la distribution gaussienne $f_o$ la plus proche.

**Claims**

**1.** Digital circuit making it possible to measure the effective voltage of an input signal, comprising at least one module exhibiting a sampler stage exhibiting an output generating an output logic signal which, for each given sampling period, exhibits a level representing the value of the voltage of the signal with respect to at least one given threshold (A), **characterized in that** it comprises a circuit (CIRC) for calculating a value representative of said effective voltage as a function of the difference between the number of times the output logic signal (S) indicates that the voltage of the input signal is above the given threshold (A) and the number of times the output logic signal (S) indicates that this voltage is below said given threshold (A) over a duration corresponding to N given sampling periods.

**2.** Circuit according to Claim 1, **characterized in that** it exhibits a switching circuit ($COD_i$) making it possible to apply a first ($A_1$) and a second ($A_2$) different given threshold to the digital circuit and **in that** it comprises a so-called circuit (CIRC) for calculating said effective voltage as a function on the one hand of the difference between the number of times the output logic signal (S) indicates that the voltage of the input signal is above the first given threshold ($A_1$) and the number of times the output logic signal (S) indicates that this voltage is below said first given threshold ($A_1$) and on the other hand as a function of the difference between the number of times the output logic signal (S) indicates that the voltage of the input signal is above the second given threshold ($A_2$) and the number of times the output logic signal (S) indicates that this voltage is below said second given threshold ($A_2$).

**3.** Circuit according to one of Claims 1 or 2, **characterized in that** the calculating circuit exhibits:

- a correlator (COR) paced by a clock (H) at said sampling period, and exhibiting a comparison logic circuit having a first input receiving said output logic signal (S) and a second so-called comparison input to which an input logic signal (0 or 1) is applied, and an output delivering at each period of the clock signal a comparison logic signal (Y) comparing between the logic signals present at the first and second inputs of the comparison logic circuit, and an accumulation circuit (ACC) for accumulating the comparison logic signal (Y) during the N sampling periods and for producing a correlation logic signal (X),
- and a circuit (CIRC) for determining a value representative of said effective voltage as a function of the difference (X') between the number of times that for each so-called given threshold the comparison logic signal (Y) is at the zero logic level and the number of times that this output is at the 1 logic level over N periods of the clock signal (H), this determination being performed on the basis of the correlation logic signal (X).

4. Circuit according to one of Claims 1 to 3, **characterized in that** said given period is the period of a clock (H) which paces the sampler stage.

5. Circuit according to Claim 4, **characterized in that** the sampler stage comprises:

   - a comparator (COMP) having a signal input for receiving the input signal and an input of a threshold level receiving a signal (A) representing the given threshold and an output generating a comparison signal (s) representing the fact that the value of the voltage of the input signal is or is not above said threshold (A).
   - a flip-flop (L) having an input connected to the output of the comparator (COMP) and an input of a clock signal (H) having said given period and an output generating said output logic signal (S) which represents for each period of said clock signal a value of the logic signal (s) at the output of the comparator (COMP).

6. Circuit according to one of Claims 3 to 6, **characterized in that** the correlator (COR) comprises an exclusive OR gate (XOR) outputting said correlation logic signal (Y).

7. Circuit according to Claim 6, **characterized in that** said gate is an inverted exclusive OR gate ($\overline{XOR}$)

8. Circuit according to one of the preceding claims, **characterized in that** a so-called representative value is proportional to:

$$X' \; = \; 2\left|X \, - \, N/2\right|/N$$

   X being the number of samples at the output of the correlater having the value 0 for a so-called given threshold, and N denoting the total number of samples.

9. Circuit according to Claims 2 to 8, **characterized in that** the accumulation circuit is a counting circuit (ACC) accumulating the value of the comparison logic signal (Y) during N sampling periods and outputting said correlation digital signal (X) representing the number of times that the comparison logic signal is at a given level (0 or 1), said digital signal (X) which constitutes the output signal from the correlator (COR) being introduced to an input of the circuit (CIRC) for determining a representative value.

10. Digital circuit **characterized in that** it exhibits n modules according to one of Claims 1 and 3 to 9, each of these n modules exhibiting one of the n different thresholds ($a_1$, $a_2$, ... $a_n$) and being arranged in parallel.

11. Digital circuit **characterized in that** it exhibits n - 1 modules according to one of the preceding claims, each of these n modules exhibiting two different thresholds, a first module exhibiting a first ($a_1$) and a second ($a_2$) threshold, a second module exhibiting the second ($a_2$) and a third ($a_3$) threshold, and so on and so forth up to the (n-1)th module which exhibits an (n-1)th threshold ($a_{n-1}$) and an nth threshold ($a_n$).

12. Circuit according to one of Claims 10 or 11, **characterized in that** it is associated with a processing circuit which, on the basis of the n output signals ($X_1$, $X_2$, .... $X_n$) from the n modules, determines an estimated frequency distribution $f_e$ of the voltage of the signal V.

13. Circuit according to Claim 12, **characterized in that** the processing circuit also exhibits a calculation module for calculating the error between said estimated distribution $f_e$ and the closest Gaussian distribution $f_o$.

**EP 1 348 968 B1**

**Patentansprüche**

1. Digitale Schaltung, die das Messen der Effektivspannung eines Eingangssignals ermöglicht, mit mindestens einem Modul, das eine Abtasterstufe aufweist, das einen Ausgang aufweist, der ein logisches Ausgangssignal erzeugt, das für jede gegebene Abtastperiode einen Pegel aufweist, der den Wert der Spannung des Signals bezogen auf mindestens einen gegebenen Schwellwert (A) repräsentiert, **dadurch gekennzeichnet, dass** sie eine Schaltung (CIRC) umfasst, welche einen für die Effektivspannung repräsentativen Wert als Funktion der Differenz zwischen der Anzahl von Malen, wie oft das logische Ausgangssignal (S) angibt, dass die Spannung des Eingangssignals über dem gegebenen Schwellwert (A) liegt, und der Anzahl von Malen, wie oft das logische Ausgangssignal (S) angibt, dass diese Spannung unter dem gegebenen Schwellwert (A) liegt, über eine N gegebenen Abtastperioden entsprechende Zeitdauer berechnet.

2. Schaltung nach Anspruch 1, **dadurch gekennzeichnet, dass** sie ein Schaltnetz ($COD_1$) aufweist, das es ermöglicht, auf die digitale Schaltung einen ersten ($A_1$) und einen zweiten ($A_2$) gegebenen Schwellwert anzuwenden, die voneinander verschieden sind, sowie dadurch, dass sie eine Rechenschaltung (CIRC) umfasst, welche die Effektivspannung einerseits als Funktion der Differenz zwischen der Anzahl von Malen, wie oft das logische Ausgangssignal (S) angibt, dass die Spannung des Eingangssignals über dem ersten gegebenen Schwellwert ($A_1$) liegt, und der Anzahl von Malen, wie oft das logische Ausgangssignal (S) angibt, dass diese Spannung unter dem ersten gegebenen Schwellwert ($A_1$) liegt, und andererseits als Funktion der Differenz zwischen der Anzahl von Malen, wie oft das logische Ausgangssignal (S) angibt, dass die Spannung des Eingangssignals über dem zweiten gegebenen Schwellwert ($A_2$) liegt, und der Anzahl von Malen, wie oft das logische Ausgangssignal (S) angibt, dass diese Spannung unter dem zweiten gegebenen Schwellwert ($A_2$) liegt, berechnet.

3. Schaltung nach einem der Ansprüche 1 oder 2, **dadurch gekennzeichnet, dass** die Rechenschaltung aufweist:

   - einen Korrelator (COR), der von einem Takt (H) mit der Abtastperiode getaktet wird und der eine logische Vergleichsschaltung mit einem ersten Eingang zum Empfangen des logischen Ausgangssignals (S) und einem zweiten, so genannten Vergleichseingang, an den ein logisches Eingangssignal (0 oder 1) angelegt wird, und einem Ausgang, der bei jeder Periode des Taktsignals ein logisches Signal des Vergleichs (Y) zwischen den am ersten und am zweiten Eingang der logischen Vergleichsschaltung vorhandenen logischen Signalen liefert, und einer Akkumulierschaltung (ACC), die das logische Vergleichssignal (Y) während der N Abtastperioden akkumuliert und ein logisches Korrelationssignal (X) erzeugt, aufweist,
   - und eine Schaltung (CIRC), welche einen für die Effektivspannung repräsentativen Wert als Funktion der Differenz (X') zwischen der Anzahl von Malen, wie oft das logische Vergleichssignal (Y) für jeden gegebenen Schwellwert auf dem logischen Pegel 0 liegt, und der Anzahl von Malen, wie oft dieser Ausgang auf dem logischen Pegel 1 liegt, über N Perioden des Taktsignals (H) bestimmt, wobei diese Bestimmung auf der Grundlage des logischen Korrelationssignals (X) stattfindet.

4. Schaltung nach einem der Ansprüche 1 bis 3, **dadurch gekennzeichnet, dass** die gegebene Periode die Periode eines die Abtasterstufe taktenden Taktes (H) ist.

5. Schaltung nach Anspruch 4, **dadurch gekennzeichnet, dass** die Abtasterstufe umfasst:

   - einen Komparator (COMP) mit einem Signaleingang zum Empfangen des Eingangssignals und einem Eingang für einen Schwellwertpegel, der ein den gegebenen Schwellwert repräsentierendes Signal (A) empfängt, und einem Ausgang zum Erzeugen eines Vergleichssignals (s), das den Umstand repräsentiert, dass der Wert der Spannung des Eingangssignals über dem Schwellwert (A) liegt oder nicht.
   - einem Flip-Flop (L) mit einem Eingang, der mit dem Ausgang des Komparators (COMP) verbunden ist, und einem Eingang eines Taktsignals (H), das die gegebene Periode aufweist, und einem Ausgang zum Erzeugen des logischen Ausgangssignals (S), das für jede Periode des Taktsignals einen Wert des logischen Signals (s) am Ausgang des Komparators (COMP) repräsentiert.

6. Schaltung nach einem der Ansprüche 3 bis 6, **dadurch gekennzeichnet, dass** der Korrelator (COR) ein Exklusiv-ODER-Glied (XOR) umfasst, das an seinem Ausgang das logische Korrelationssignal (Y) liefert.

7. Schaltung nach Anspruch 6, **dadurch gekennzeichnet, dass** das Gatter ein invertiertes Exklusiv-ODER-Glied ($\overline{XOR}$) ist.

**8.** Schaltung nach einem der vorherigen Ansprüche, **dadurch gekennzeichnet, dass** ein solcher repräsentativer Wert proportional ist zu:

$$X' = 2\left|X - N/2\right|/N$$

wobei X die Anzahl von Abtastproben am Ausgang des Korrelators ist, die für einen solchen gegebenen Schwellwert den Wert 0 aufweisen, und N die Gesamtanzahl von Abtastproben bezeichnet.

**9.** Schaltung nach den Ansprüchen 2 bis 8, **dadurch gekennzeichnet, dass** die Akkumulierschaltung eine Zählschaltung (ACC) ist, welche während N Abtastperioden den Wert des logischen Vergleichssignals (Y) akkumuliert und am Ausgang das digitale Korrelationssignal (X) liefert, das die Anzahl von Malen repräsentiert, wie oft das logische Vergleichssignal auf einem gegebenen Pegel (0 oder 1) liegt, wobei das digitale Signal (X), welches das Ausgangssignal des Korrelators (COR) darstellt, an einen Eingang der Schaltung (CIRC) zum Bestimmen eines repräsentativen Wertes eingegeben wird.

**10.** Digitale Schaltung, **dadurch gekennzeichnet, dass** sie n Module nach einem der Ansprüche 1 und 3 bis 9 aufweist, wobei diese n Module jeweils einen von n verschiedenen Schwellwerten ($a_1$, $a_2$, ... $a_n$) aufweisen und parallel geschaltet sind.

**11.** Digitale Schaltung, **dadurch gekennzeichnet, dass** sie n-1 Module nach einem der vorherigen Ansprüche aufweist, wobei die n Module jeweils zwei verschiedene Schwellwerte aufweisen, so dass ein erstes Modul einen ersten ($a_1$) und einen zweiten ($a_2$) Schwellwert aufweist, ein zweites Modul den zweiten ($a_2$) und einen dritten ($a_3$) Schwellwert aufweist, und so fort bis zum (n-1)-ten Modul, das einen (n-1)-ten Schwellwert ($a_{n-1}$) und einen n-ten Schwellwert (an) aufweist.

**12.** Schaltung nach einem der Ansprüche 10 oder 11, **dadurch gekennzeichnet, dass** sie einer Verarbeitungsschaltung zugeordnet ist, die auf der Grundlage der n Ausgangssignale ($X_1$, $X_2$, .... $X_n$) der n Module eine geschätzte Häufigkeitsverteilung $f_e$ der Spannung des Signals V bestimmt.

**13.** Schaltung nach Anspruch 12, **dadurch gekennzeichnet, dass** die Verarbeitungsschaltung ferner ein Rechenmodul zum Berechnen des Fehlers zwischen der geschätzten Verteilung $f_e$ und der nächstliegenden Normalverteilung $f_o$ aufweist.

FIG.1

FIG.2

FIG.3a

FIG.3b

FIG.3c

FIG.3d

FIG.4

FIG.5

14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MARTTI E. TIURI.** Digital Measurement of Narrowband Noise Power. *Proceedings of the IEEE,* Septembre 1967, vol. 55 (9

- **FAWWAZ T. ULABY.** Microwave Remote Sensing. *Microwave Remote Sensing - Fundamentals and Radiometry,* vol. 1, 369-374